# EUROPÄISCHE PATENTANMELDUNG

(11) **EP 4 800 407 A1**
(43) Veröffentlichungstag der Anmeldung: **02.09.2026**
(21) Anmeldenummer: 25160955.8
(22) Anmeldetag: 28.02.2025
(51) Int. Cl.: G01R 31/392, G01R 31/3835, G01R 31/388

(54) **ERMITTLUNG EINES KRITISCHEN BATTERIEMODULS SOWIE DESSEN VERWENDUNG, COMPUTERPROGRAMMPRODUKT**

(71) Anmelder: Siemens Aktiengesellschaft, 80333 München (DE)
(72) Erfinder: Fischer, Michael, 91320 Ebermannstadt (DE); Chan, Hoon Seng, 91052 Erlangen (DE); Radinger, Hannes, 86152 Augsburg (DE); Schricker, Barbara, 91058 Erlangen (DE)
(74) Vertreter: Siemens Patent Attorneys

(57) **Zusammenfassung**

Die Erfindung betrifft ein Verfahren zur Ermittlung eines kritischen Batteriemoduls (1), wobei das Batteriemodul (1) kritisch ist, wenn es mindestens eine Batteriezelle mit einem Gesundheitszustand kleiner oder gleich einem festgelegten Schwellenwert umfasst. Das Verfahren umfasst:
- Beaufschlagen des Batteriemoduls (1) mit einer Stromstärke;
- Erfassen eines zeitlichen Abklingverlaufs (208) der Spannung des Batteriemoduls (1) nach einem Abschalten der Stromstärke; und
- Ermitteln des Batteriemoduls (1) als kritisch, wenn der erfasste Abklingverlauf (208) der Spannung einen festgelegten Toleranzbereich (2) verletzt.

Weiterhin betrifft die Erfindung eine Verwendung eines Batteriemoduls in Abhängigkeit seiner Kritikalität sowie ein Computerprogrammprodukt.

## Beschreibung

Die vorliegende Erfindung betrifft eine Analyse von Batteriemodulen und insbesondere ein Verfahren zur Ermittlung eines kritischen Batteriemoduls gemäß Anspruch 1, eine Verwendung eines Batteriemoduls gemäß Anspruch 13 sowie ein Computerprogrammprodukt gemäß Anspruch 15.

Der Bereich der Batterietechnologie hat in den letzten Jahren, insbesondere angetrieben durch die steigende Nachfrage nach effizienten und zuverlässigen Energiespeicherlösungen, an Bedeutung gewonnen. Batteriespeicher beziehungsweise Batterien sind für verschiedenste Anwendungen relevant, von tragbaren elektronischen Geräten über Elektrofahrzeuge bis hin zu großen Energiespeichersystemen. Mit der zunehmenden Abhängigkeit von batteriebetriebenen Geräten und Systemen wächst die Bedeutung einer möglichst genauen Bewertung der Batteriegesundheit und der Batterieleistung.

Batteriemodule, die mehrere einzelne Batteriezellen beziehungsweise Zellen umfassen, wobei die Zellen in Reihen- und/oder Parallelschaltung verbunden sind, werden typischerweise verwendet, um die Leistungs- und Energieanforderungen verschiedener Anwendungen zu erfüllen. Diese Module bieten Vorteile in Bezug auf Skalierbarkeit, Flexibilität und Gesamtsystemleistung. Die Komplexität von Batteriemodulen stellt jedoch Herausforderungen in Bezug auf die Überwachung und Aufrechterhaltung ihrer Gesundheit (englisch: State of Health, SOH) und Effizienz im Laufe der Zeit dar.

Ein wichtiger Aspekt des Batteriemodulmanagements ist die Möglichkeit, den Gesundheitszustand (SOH) einzelner Zellen innerhalb des Moduls zu ermitteln. Der SOH ist ein Maß für den Zustand einer Batterie im Verhältnis zu ihrer idealen beziehungsweise Anfangskapazität und wird typischerweise als Prozentsatz angegeben. Mit zunehmendem Alter und/oder wiederholten Lade-Entlade-Zyklen kann sich die Leistung von Batterien verschlechtern, was zu einer verringerten Kapazität und einem erhöhten Innenwiderstand führt. Diese Verschlechterung tritt möglicherweise nicht gleichmäßig über alle Zellen in einem Modul auf, was es entscheidend macht, leistungsschwache oder "kritische" Zellen zu identifizieren, da diese kritischen Zellen die Gesamtleistung des Moduls negativ beeinflussen können.

Typische Verfahren zur Bewertung der Batteriegesundheit beruhen auf direkten Messungen der Spannungen einzelner Zellen, was in großen Batteriemodulen ohne Zugang zu internen Verbindungen eine Herausforderung darstellt. Weiterhin bieten diese Methoden möglicherweise kein umfassendes Verständnis des dynamischen Verhaltens von Zellen unter verschiedenen Betriebsbedingungen. Somit besteht ein wachsender Bedarf an nicht-invasiven Techniken, die den Gesundheitszustand einzelner Zellen innerhalb eines Batteriemoduls ermitteln können, ohne einen direkten Zugang zu jeder Zelle zu erfordern.

Der vorliegenden Erfindung liegt die Aufgabe zugrunde, eine Ermittlung kritischer Batteriemodule, die Zellen mit verschlechtertem Gesundheitszustand umfassen, insbesondere ohne direkten Zugang zu einzelnen Zellen, zu ermöglichen.

Die Aufgabe wird durch ein Verfahren mit den Merkmalen des unabhängigen Anspruchs 1, durch eine Verwendung mit den Merkmalen des unabhängigen Anspruchs 13 sowie durch ein Computerprogrammprodukt mit den Merkmalen des unabhängigen Anspruchs 15 gelöst. In den abhängigen Patentansprüchen sind vorteilhafte Ausgestaltungen und Weiterbildungen der Erfindung angegeben.

Das erfindungsgemäße Verfahren zur Ermittlung eines kritischen Batteriemoduls, wobei das Batteriemodul kritisch ist, wenn es mindestens eine Batteriezelle mit einem Gesundheitszustand kleiner oder gleich einem festgelegten Schwellenwert umfasst, ist durch die folgenden Schritte gekennzeichnet:
- Beaufschlagen des Batteriemoduls mit einer Stromstärkestärke;
- Erfassen eines zeitlichen Abklingverlaufs der Spannung des Batteriemoduls nach einem Abschalten der Stromstärke; und
- Ermitteln des Batteriemoduls als kritisch, wenn der erfasste Abklingverlauf der Spannung einen festgelegten Toleranzbereich verletzt.

Ein Batteriemodul ist typischerweise eine Anordnung mehrerer Batteriezellen, die elektrisch in Reihen- und/oder Parallelschaltung verbunden sind, beispielsweise um eine gewünschte Spannung und/oder Kapazität bereitzustellen. Ein Batteriemodul kann zusätzliche Komponenten, wie beispielsweise Sensoren, Steuerungselektronik und/oder Thermomanagementsysteme, umfassen.

Ein kritisches Batteriemodul ist ein Batteriemodul, das mindestens eine Batteriezelle mit einem Gesundheitszustand kleiner oder gleich dem festgelegten Schwellenwert umfasst. Eine Zelle mit einem solchen Gesundheitszustand kann als kritische Zelle bezeichnet werden. Ein nicht-kritisches Batteriemodul ist ein Batteriemodul, welches nur Zellen umfasst, deren jeweiliger Gesundheitszustand größer als der festgelegte Schwellenwert ist. Der Begriff der Kritikalität des Batteriemoduls bezieht sich darauf, ob das Batteriemodul eine oder mehrere kritische Zellen oder keine kritischen Zellen umfasst. Typischerweise weist die Kritikalität eines Batteriemoduls auf potenzielle Leistungsprobleme und/oder Sicherheitsprobleme hin.

Das Ermitteln eines kritischen Batteriemoduls kann ebenfalls als Bewertung des Batteriemoduls bezüglich seiner Kritikalität und/oder als Verfahren zur Erkennung von kritischen Batteriemodulen aufgefasst werden.

Ein Gesundheitszustand einer Batteriezelle bezieht sich typischerweise auf ein Maß für ihren aktuellen Zustand im Verhältnis zu ihrem idealen und/oder anfänglichen Zustand. Er wird typischerweise als Prozentsatz ausgedrückt und kann abhängig von Faktoren, wie beispielsweise Kapazitätserhaltung, Innenwiderstand und/oder allgemeine Leistungsverschlechterung im Laufe der Zeit sein.

Ein Zeitlicher Abklingverlauf beschreibt das zeitabhängige Abklingverhalten der Spannung, die erfasst wird, nachdem eine an ein Batteriemodul angelegte Stromstärke abgeschaltet wurde.

Ein Toleranzbereich ist ein vorab festgelegter Spannungsbereich von technisch akzeptablen Abklingverläufen. Er kann durch eine obere und untere Spannungskennlinien definiert sein. Der Toleranzbereich wird verwendet, um zu ermitteln, ob ein Batteriemodul kritisch oder nicht-kritisch ist.

Eine Zeitkonstante oder Zeitskala des Abklingverlaufs ist ein Parameter, der die Geschwindigkeit charakterisiert, mit der die Spannung im Laufe der Zeit abnimmt.

Eine Überspannung bezieht sich auf die Differenz zwischen einer gemessenen Spannung eines Batteriemoduls und seiner Ruhespannung.

Eine Padé-Laplace-Methode ist ein Verfahren, das verwendet werden kann, um insbesondere Zeitkonstanten aus gemessenen Abklingkurven zu ermitteln. Mit der Padé-Laplace-Methode beziehungsweise dem Padé-Laplace-Verfahren können mehrere Zeitkonstanten, die zusammen das erfasste Abklingverhalten ausbilden und sich hierbei überlagern, ermittelt werden. Hierzu kann der Laplace-transformierte Abklingverlauf mittels einer Padé-Näherung approximiert werden, wobei die Zeitkonstanten durch die Pole der Padé-Näherung und ihre Amplituden durch die Residuen der Padé-Näherung ausgebildet werden.

Die Erfindung weist wenigstens einen oder mehrere der folgenden Vorteile auf:
Nicht-invasive Bewertung: Das Verfahren kann ohne einen direkten Zugang zu den einzelnen Zellen des Batteriemoduls durchgeführt werden. Dadurch ermöglicht die Erfindung die Bewertung des Zellzustands, ohne das Modul zu zerlegen und/oder physisch auf die internen Komponenten zuzugreifen. Dieser nicht-invasive Ansatz reduziert den Zeit- und Kostenaufwand sowie potenzielle Risiken bei der Batteriediagnose.

Umfassendere Analyse: Durch die Untersuchung des zeitlichen Abklingverlaufs liefert die Methode Einblicke in das dynamische Verhalten der Batteriezellen. Dadurch können mehr Informationen über die internen Eigenschaften der Zellen erfasst werden.

Erkennung von Einzelzellendegradation: Die Erfindung ist in der Lage, das Vorhandensein einer oder mehrerer degradierter Zellen (kritische Zellen) innerhalb eines Batteriemoduls zu identifizieren. Dies ist besonders vorteilhaft für in Reihe geschaltete Zellen, bei denen eine einzelne leistungsschwache Zelle die Gesamtleistung des Moduls erheblich beeinflussen kann. Bekannte Verfahren, die lediglich die Gesamteigenschaften des Moduls messen, können solche lokalisierten Degradationen übersehen beziehungsweise nicht zellspezifisch auflösen.

Anpassungsfähigkeit an verschiedene Batterietypen: Das Verfahren kann für verschiedene Batteriechemien und/oder -konfigurationen verwendet werden. Insbesondere ohne spezifische Informationen über die interne Zellstruktur und/oder -chemie zu erfordern. Diese Vielseitigkeit macht das Verfahren für ein breites Spektrum von Anwendungen geeignet.

Echtzeit-Diagnostik: Die Analyse des Abklingverlaufs der Spannung kann relativ schnell durchgeführt werden, was eine Echtzeit- oder Nahezu-Echtzeit-Bewertung des Batteriezustands ermöglicht. Dies ermöglicht eine häufigere und zeitnahe Überwachung des Batteriezustands und erleichtert eine proaktive Wartung und Optimierung der Batterienutzung.

Verbesserte Genauigkeit: Durch die Definition eines Toleranzbereichs, der Fertigungsschwankungen und/oder erwartete Degradationsmuster berücksichtigt, verbessert das Verfahren die Genauigkeit bei der Identifizierung von kritischen Batteriemodulen. Dies führt zu zuverlässigeren Diagnosen und einem verbesserten Batteriemanagement.

Kosteneffektive Implementierung: Das Verfahren kann mittels einfacher und bekannter elektrischer Messgeräte und Datenanalysetechniken implementiert werden. Dadurch stellt das Verfahren eine kosteneffektive und technisch effiziente Lösung für die Bewertung des Batteriezustands bereit.

Erhöhte Sicherheit: Die frühzeitige Erkennung kritischer Batteriemodule kann potenzielle Sicherheitsrisiken verhindern, die mit stark degradierten Zellen verbunden sind, wie thermisches Durchgehen und/oder unerwartete Ausfälle während des Betriebs. Dies ist besonders wichtig bei Hochleistungsanwendungen, wie beispielsweise Elektrofahrzeugen und/oder Speichersysteme für Stromnetze.

Optimierung des Batterie-Lebenszyklus-Managements: Durch die Identifizierung kritischer Module ermöglicht die Methode effizientere und technisch basierte Entscheidungen bezüglich der Wiederverwendung, Wiederaufbereitung oder des Recyclings von Batterien. Dies trägt zu einer verbesserten Ressourcennutzung bei und unterstützt nachhaltige Praktiken im Batteriemanagement.

Skalierbarkeit: Das Verfahren ist von kleinen Batteriemodulen bis hin zu großen Batteriesystemen verwendbar. Dadurch ist das Verfahren für ein breites Spektrum von Anwendungen geeignet, von Unterhaltungselektronik bis zur industriellen Energiespeicherung.

Integration in bestehende Systeme: Das Verfahren kann in bestehende Batteriemanagementsysteme (BMS), Energiemanagementsysteme (EMS) und/oder Qualitätskontrollprozesse integriert werden und erweitert deren Fähigkeiten, ohne signifikante Änderungen an etablierten Arbeitsabläufen zu erfordern.

Datengestützte Erkenntnisse: Die Analyse liefert wertvolle Daten, die zur Erstellung genauerer Modelle der Batteriealterung und Leistungsverschlechterung im Laufe der Zeit verwendet werden können. Dies kann zukünftige Batteriedesigns beeinflussen und die Gesamtzuverlässigkeit des Systems verbessern.

Die erfindungsgemäße Verwendung eines Batteriemoduls, die davon abhängig ist, ob das Batteriemodul kritisch ist, wobei das Batteriemodul kritisch ist, wenn es eine oder mehrere Batteriezellen mit einem Gesundheitszustand kleiner oder gleich einem festgelegten Schwellenwert umfasst, ist dadurch gekennzeichnet, dass die Ermittlung der Kritikalität des Batteriemoduls mittels eines Verfahrens gemäß einem der Ansprüche 1 bis 12 durchgeführt wird.

Es ergeben sich zum erfindungsgemäßen Verfahren gleichartige, gleichwertige und gleichwirkende Vorteile.

Das erfindungsgemäße Computerprogrammprodukt umfasst Befehle, die, wenn sie von einer Recheneinheit, insbesondere einem Computer, ausgeführt werden, diese veranlassen, ein Verfahren und/oder Schritte des Verfahrens gemäß einem der Ansprüche 1 bis 14 auszuführen.

Es ergeben sich zum erfindungsgemäßen Verfahren gleichartige, gleichwertige und gleichwirkende Vorteile.

Gemäß einer bevorzugten Ausgestaltung der Erfindung wird eine Überspannung des Batteriemoduls als Spannung verwendet.

Die Verwendung der Überspannung bietet mehrere Vorteile für die Ermittlung der Kritikalität eines Batteriemoduls. Die Überspannung, die die Differenz zwischen der gemessenen Spannung und der Ruhespannung ist, reagiert besonders empfindlich auf Änderungen des Innenwiderstands der Batteriezellen. Diese Empfindlichkeit ermöglicht eine genauere Erkennung von degradierten beziehungsweise kritischen Zellen innerhalb des Moduls. Wird die Ruhespannung im Abklingverlauf der Überspannung im Wesentlichen erreicht, so weist die Überspannung den Wert Null auf. Weiterhin kann die Analyse des Abklingverlaufs der Überspannung vorteilhafte Information über das dynamische Verhalten der Zellen unter verschiedenen Lastbedingungen liefern.

Gemäß einer bevorzugten Ausgestaltung der Erfindung wird der Toleranzbereich durch zwei Spannungskennlinien begrenzt.

Mit anderen Worten wird der Toleranzbereich durch eine untere und obere Spannungskennlinie begrenzt beziehungsweise ausgebildet. Die Definition des Toleranzbereichs mit oberen und unteren Spannungskennlinien ist besonders vorteilhaft für die Identifizierung kritischer Batteriemodule. Durch die Verwendung eines Bereichs wird die Berücksichtigung von Fertigungsschwankungen und erwarteten Degradationsmustern möglich. Dadurch können falsch positive Ergebnisse im Erkennungsprozess reduziert werden. Die Spannungskennlinien beziehungsweise der Toleranzbereich kann batteriespezifisch sein, das heißt beispielsweise an spezifische Batteriearten, Batteriechemien, Batteriedesigns und/oder Anwendungsanforderungen angepasst sein. Weiterhin kann der Toleranzbereich temperaturabhängig, ladezustandsabhängig und/oder abhängig vom Alter der Batterie sein. Der Toleranzbereich und/oder die Spannungskennlinien können mittels Referenzmessungen für nicht-kritischen Batteriemodule bereitgestellt und festgelegt werden.

Gemäß einer bevorzugten Ausgestaltung der Erfindung werden eine oder mehrere Zeitkonstanten des Abklingverlaufs der Spannung ermittelt, wobei die Verletzung des Toleranzbereichs mittels der ermittelten Zeitkonstanten ermittelt wird.

Die Verwendung von Zeitkonstanten liefert ein quantitatives Maß für den Abklingverlauf der Spannung. Dadurch wird eine differenziertere Analyse des Batteriemodulzustands ermöglicht. Zeitkonstanten können mit spezifischen physikalischen Prozessen innerhalb der Batteriezellen korreliert werden, wie beispielsweise Ladungsübertragung und/oder Diffusion, sodass genauere Informationen über Art einer möglichen Degradation bereitgestellt werden können. Weiterhin könnten eine Analyse der Steigung des Abklingverhaltens an bestimmten Punkten und/oder die Verwendung von Frequenzbereichsanalysetechniken zur Charakterisierung des Abklingverlaufs verwendet werden.

Gemäß einer bevorzugten Ausgestaltung der Erfindung werden die Zeitkonstanten mittels einer Fits des Abklingverlaufs der Spannung ermittelt.

Ein Fits des Abklingverlaufs ermöglicht eine verbesserte Ermittlung der Zeitkonstanten, insbesondere bei Vorhandensein von Rauschen und/oder Messunsicherheiten. Weiterhin können dadurch zusätzliche Parameter bereitgestellt werden, die das Abklingverhalten der Spannung charakterisieren und detailliertere Informationen über den Zustand des Batteriemoduls bieten. Alternative Fit-Verfahren könnten die Verwendung verschiedener mathematischer Modelle wie Exponentialsummen, Polynomanpassungen und/oder auf maschinelle Lernverfahren basierte Regressionstechniken umfassen.

Gemäß einer bevorzugten Ausgestaltung der Erfindung werden die Zeitkonstanten des Abklingverlaufs der Spannung durch eine Padé-Laplace-Methode ermittelt.

Die Padé-Laplace-Methode bietet Vorteile in Bezug auf numerische Stabilität und Genauigkeit, insbesondere für Systeme mit mehreren Zeitkonstanten. Mittels des Padé-Laplace-Verfahrens können mehrere Komponenten bezüglich ihres verschiedenen Abklingverhaltens effektiv getrennt beziehungsweise aufgelöst oder ermittelt werden. Dadurch wird es möglich, spezifische Degradationsmechanismen mittels ihrer unterschiedlichen Zeitkonstanten innerhalb der Batteriezellen zu identifizieren. Ein besonderer Vorteil des Padé-Laplace-Verfahrens gegenüber einem Fit-Verfahren ist somit, dass die einzelnen Zeitkonstanten, die zu einem gemeinsamen Abklingverlauf führen, ermittelt werden können. Durch die ermittelten Zeitkonstanten kann dann überprüft werden, ob diese mit dem Toleranzbereich beziehungsweise mit einem Bereich von zulässigen Werten für die Zeitkonstanten verträglich sind oder diesen verletzen.

Gemäß einer bevorzugten Ausgestaltung der Erfindung erfolgt zur Ermittlung der Verletzung des Toleranzbereichs eine Normierung des Abklingverhaltens beziehungsweise des Abklingverlauf der Spannung auf einen ihrer Werte.

Die Normierung des Abklingverlaufs ermöglicht einen einfacheren Vergleich zwischen verschiedenen Batteriemodulen und/oder Messungen und reduziert den Einfluss von Schwankungen in den absoluten Spannungswerten. Dieser Ansatz kann relative Änderungen im Abklingverlaufs hervorheben, die möglicherweise aussagekräftiger für die Zelldegradation sind als absolute Spannungswerte.

Gemäß einer bevorzugten Ausgestaltung der Erfindung wird der Stromstärke in Abhängigkeit von einer festgelegten Ruhespannung des Batteriemoduls eingestellt.

Die Einstellung der angelegten Stromstärke basierend auf der Ruhespannung stellt sicher, dass die Testbedingungen über verschiedene Batteriemodule und Ladezustände hinweg konsistent sind. Dadurch kann die Vergleichbarkeit der Ergebnisse und die Zuverlässigkeit der Kritikalitätsermittlung verbessert werden. Weiterhin kann die Stromstärke in Abhängigkeit einer Zeitdauer der Beaufschlagung und/oder einer Temperatur eingestellt werden.

Gemäß einer bevorzugten Ausgestaltung der Erfindung wird der Toleranzbereich derart festgelegt, dass er Fertigungstoleranzen des Batteriemoduls und/oder seiner Batteriezellen berücksichtigt.

Die Berücksichtigung von Fertigungstoleranzen erhöht die Robustheit der Kritikalitätsermittlung und reduziert falsch positive Ergebnisse aufgrund normaler Schwankungen in den Zelleigenschaften. Dies besonders vorteilhaft für umfangreiche Batteriemodultests in Produktionsumgebungen.

Gemäß einer bevorzugten Ausgestaltung der Erfindung wird als Schwellenwert für den Gesundheitszustand der Batteriezellen ein Wert von 80 Prozent, vorzugsweise 70 Prozent, besonders bevorzugt 60 Prozent festgelegt.

Die Festlegung spezifischer Schwellenwerte für den Zellgesundheitszustand bietet objektiv nachvollziehbare Kriterien zur Ermittlung der Kritikalität von Batteriemodulen. Diese Werte können basierend auf Anwendungsanforderungen, Sicherheitsüberlegungen oder wirtschaftlichen Faktoren im Zusammenhang mit dem Batterie-Lebenszyklus-Management festgelegt werden. Alternativ oder ergänzend können mehrerer Schwellenwerte zur Kategorisierung von Batteriemodulen in verschiedene Kritikalitätsstufen und/oder adaptive Schwellenwerte verwendet werden, die sich beispielsweise basierend auf dem Alter und/oder der Nutzungshistorie des Batteriemoduls ändern.

Gemäß einer bevorzugten Ausgestaltung der Erfindung wird der zeitliche Abklingverlauf der Spannung mit einer zeitlichen Auflösung im Bereich von 1 Millisekunde bis 100 Millisekunden erfasst.

Eine ausreichend hohe zeitliche Auflösung bei der Erfassung des Abklingverlaufs der Spannung ermöglicht eine Erfassung von dynamischen Prozessen innerhalb der Batteriezellen. Dadurch können kritische Batteriemodulen verbessert erkannt beziehungsweise ermittelt werden. Weiterhin können dadurch spezifische Degradationsmechanismen identifizieren werden oder zukünftige Leistungsprobleme vorhergesagt werden.

Gemäß einer bevorzugten Ausgestaltung der Erfindung wird die Spannung mit einer relativen Genauigkeit im Bereich von 0,1 Prozent bis 5 Prozent, insbesondere im Bereich von 0,1 Prozent bis 1 Prozent, bezüglich eines Maximalwerts der Spannung erfasst. Spannungsmessungen mit der genannten Genauigkeit ermöglichen die Erkennung kleiner Variationen im Abklingverlauf beziehungsweise im Abklingverhalten, die insbesondere auf frühe Stadien der Zelldegradation hinweisen können. Diese genannte Genauigkeit kann die Empfindlichkeit und Zuverlässigkeit der Kritikalitätsermittlung verbessern und potenziell eine frühere Identifizierung problematischer Zellen ermöglichen.

Gemäß einer bevorzugten Ausgestaltung der Erfindung ist die Verwendung in Abhängigkeit von der Anzahl der Batteriezellen mit einem Gesundheitszustand kleiner oder gleich dem festgelegten Schwellenwert eine Wiederverwendung, Wiederaufbereitung oder Recycling des Batteriemoduls.

Mit anderen Worten ist die Verwendung beziehungsweise die Art der weiteren Verwendung des Batteriemoduls von der Anzahl der ermittelten kritischen Batteriezellen abhängig. Dadurch wird vorteilhafterweise ein optimiertes Lebenszyklus-Management von Batteriemodulen basierend auf ihrem ermittelten Zustand möglich. Eine Wiederverwendung von Modulen mit wenigen oder keinen kritischen Zellen kann ihre Betriebsdauer in weniger anspruchsvollen Anwendungen verlängern. Eine Wiederaufbereitung, die den Austausch und/oder die Rekonditionierung einzelner Zellen umfassen kann, kann für Module mit einer begrenzten Anzahl kritischer Zellen sinnvoll sein. Recycling ist für Module mit einer hohen Anzahl kritischer Zellen bevorzugt, wobei dadurch eine ordnungsgemäße Materialrückgewinnung und Entsorgung sichergestellt wird.

Weitere Vorteile, Merkmale und Einzelheiten der Erfindung ergeben sich aus den im Folgenden beschriebenen Ausführungsbeispielen sowie anhand der Zeichnungen. Dabei zeigen schematisiert:
- Figur 1: ein Blockdiagramm eines Systems zur Analyse und Ermittlung der Verwendung einer Batterie; und
- Figur 2: ein Diagramm, das den Abklingverlauf der Spannung beziehungsweise Überspannung über die Zeit für nicht-kritische und kritische Batteriemodule zeigt.

Gleichartige, gleichwertige oder gleichwirkende Elemente können in einer der Figuren oder in den Figuren mit denselben Bezugszeichen versehen sein.

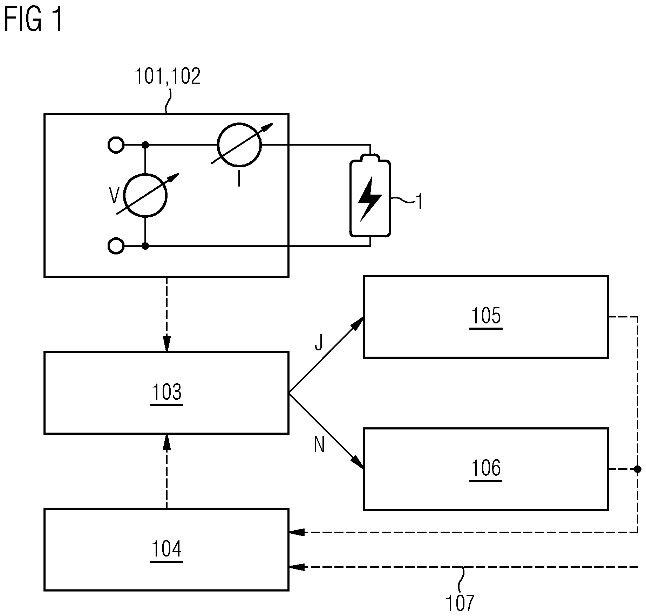

Die Figur 1 zeigt ein Blockdiagramm eines Systems zur Analyse und Ermittlung der Verwendung eines Batteriemoduls 1 beziehungsweise ein Ablaufdiagramm eines Verfahrens zur Ermittlung von kritischen Batteriemodulen gemäß einer Ausgestaltung der Erfindung.

Das System umfasst mehrere miteinander verbundene Komponenten, die zusammenarbeiten, um den Gesundheitszustand und die Kritikalität des Batteriemoduls zu ermitteln.

Das System umfasst eine Messelektronik, die für ein Beaufschlagen eines Batteriemoduls 1 mit einer Stromstärke (Schritt 101) sowie einem Erfassen einer Batteriespannung, insbesondere eines Abklingverlaufs der Spannung nach einem Ausschalten der Stromstärke (Schritt 102), ausgebildet ist.

Das System umfasst weiterhin eine Recheneinheit, dargestellt durch den Schritt 103, der die gemessenen Daten analysiert, um festzustellen, ob das Batteriemodul 1 kritisch ist. Der Schritt 103 umfasst den Vergleich des erfassten Abklingverlaufs der Spannung mit einem festgelegten Toleranzbereich.

In der Figur 1 ist eine zusätzliche Komponente, die eine Verwendung weiterer Daten/Informationen ermöglicht (Schritt 104), beispielsweise von Referenzmessungen, Parameter bezüglich des Batterietyps und historischer Daten. Diese Datenbank kann mit neuen Messungen und Analyseergebnissen aktualisiert werden, wodurch die Genauigkeit des Systems im Laufe der Zeit verbessert wird (Schritt 107).

Basierend auf der Analyse des Batteriemoduls 1 bezüglich seiner Kritikalität wird eine Verwendung beziehungsweise eine weitere Verwendung des Batteriemoduls ermittelt. Wird ermittelt, dass das Batteriemodul nicht-kritisch ist, kann es für eine Wiederverwendung 105 und/oder Wiederaufbereitung 105 verwendet werden (siehe J in der Figur 1). Dies könnte die Umnutzung des Batteriemoduls 1 für weniger anspruchsvolle Anwendungen und/oder die Wiederaufbereitung für die weitere Verwendung in ihrer ursprünglichen Anwendung umfassen. Wird ermittelt, dass das Batteriemodul 1 kritisch ist, kann es einem Recycling 106 zugeführt werden (siehe N in der Figur 1).

Weiterhin könnte die Messelektronik 101, 102 so konzipiert werden, dass sie mit verschiedenen Arten von Batteriemodulen kompatibel ist, was eine vielseitige Anwendung über verschiedene Batterietechnologien und Formfaktoren hinweg ermöglicht.

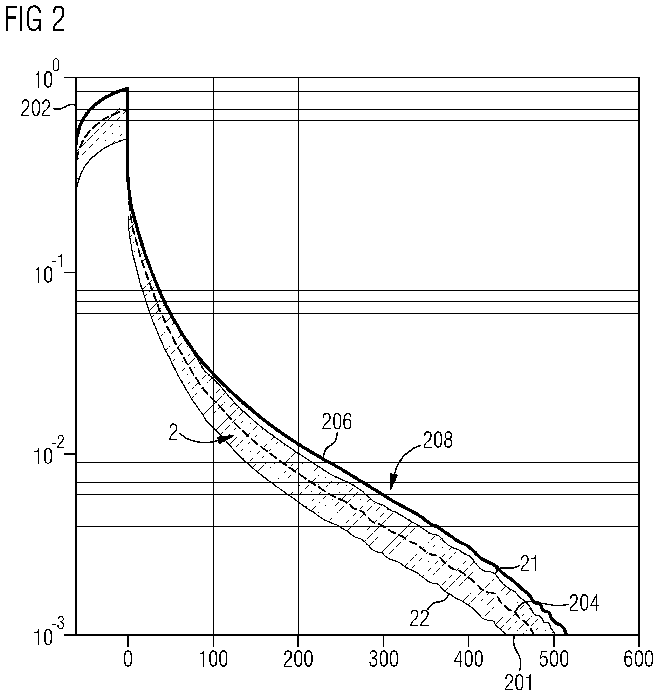

Die Figur 2 zeigt ein Diagramm, das den Abklingverlauf der Spannung beziehungsweise Überspannung über die Zeit für mehrere Batteriemodule exemplarisch darstellt und speziell die Unterschiede zwischen kritischen und nicht-kritischen Modulen veranschaulicht.

Die Abszisse 201 repräsentiert die Zeit, während die Ordinate 202 die Spannung darstellt.

Das Diagramm zeigt zwei Spannungsverläufe 204, 206, die zu einem nicht-kritischen Batteriemodul 204 sowie einem kritischen Batteriemodul 206 korrespondieren. Die genannten Kurven 204, 206 veranschaulichen den jeweiligen zeitlichen Abklingverlauf 208 der Spannung nach dem Abschalten der Stromstärke, wie obenstehend beschrieben.

Weiterhin ist ein Toleranzbereich 2 dargestellt, der durch eine obere Spannungskennlinie 21, 22 begrenzt beziehungsweise ausgebildet wird. Dieser Toleranzbereich 2 dient als Kriterium zur Ermittlung, ob ein Batteriemodul kritisch ist.

Der Abklingverlauf 208 des kritischen Batteriemoduls 206 verletzt den Toleranzbereich 2, was darauf hinweist, dass es eine oder mehrere Zellen mit einem Gesundheitszustand unterhalb des festgelegten Schwellenwerts umfasst. Im Gegensatz dazu verbleibt der Abklingverlauf des nicht-kritischen Batteriemoduls 204 während des gesamten Messzeitraums innerhalb des Toleranzbereichs 2.

Das Diagramm veranschaulicht, wie das Verfahren kritische und nicht-kritischen Batteriemodule basierend auf ihren verschiedenen Abklingverläufen ermitteln kann.

Die jeweiligen Abklingverläufe könnten weiter analysiert werden, um ihre zugehörigen Zeitkonstanten zu ermitteln. Die Zeitkonstanten könnten mittels Fits und/oder mittels eines Padé-Laplace-Verfahrens ermittelt werden.

Obwohl die Erfindung im Detail durch die bevorzugten Ausführungsbeispiele näher illustriert und beschrieben wurde, so ist die Erfindung nicht durch die offenbarten Beispiele eingeschränkt oder andere Variationen können vom Fachmann hieraus abgeleitet werden, ohne den Schutzumfang der Erfindung zu verlassen.

### Bezugszeichenliste

- 1: Batteriemodul
- 2: Toleranzbereich
- 21: Obere Spannungscharakteristik
- 22: Untere Spannungscharakteristik
- 101: Erster Schritt
- 102: Zweiter Schritt
- 103: Dritter Schritt
- 104: Zusätzliche Daten
- 105: Wiederverwendung oder Wiederaufbereitung
- 106: Recycling
- 107: Zusätzliche Messungen
- 201: Abszisse
- 202: Ordinate
- 204: Nicht-kritisches Batteriemodul
- 206: Kritisches Batteriemodul
- 208: Abklingverlauf

## Patentansprüche

1. Verfahren zur Ermittlung eines kritischen Batteriemoduls (1), wobei das Batteriemodul (1) kritisch ist, wenn es mindestens eine Batteriezelle mit einem Gesundheitszustand kleiner oder gleich einem festgelegten Schwellenwert umfasst, **gekennzeichnet durch** folgende Schritte:
- (101) Beaufschlagen des Batteriemoduls (1) mit einer Stromstärke;
- (102) Erfassen eines zeitlichen Abklingverlaufs (208) der Spannung des Batteriemoduls (1) nach einem Abschalten der Stromstärke; und
- (103) Ermitteln des Batteriemoduls (1) als kritisch, wenn der erfasste Abklingverlauf (208) der Spannung einen festgelegten Toleranzbereich (2) verletzt.

2. Verfahren gemäß Anspruch 1, **dadurch gekennzeichnet, dass** eine Überspannung des Batteriemoduls (1) als Spannung verwendet wird.

3. Verfahren gemäß Anspruch 1 oder 2, **dadurch gekennzeichnet, dass** der Toleranzbereich (2) durch zwei Spannungskennlinien (21, 22) begrenzt wird.

4. Verfahren gemäß einem der vorhergehenden Ansprüche, **dadurch gekennzeichnet, dass** eine oder mehrere Zeitkonstanten des Abklingverlaufs (208) der Spannung ermittelt werden, wobei die Verletzung des Toleranzbereichs (2) mittels der ermittelten Zeitkonstanten ermittelt wird.

5. Verfahren gemäß Anspruch 4, **dadurch gekennzeichnet, dass** die Zeitkonstanten mittels eines Fits des Abklingverlaufs (208) der Spannung ermittelt werden.

6. Verfahren gemäß einem der vorhergehenden Ansprüche, **dadurch gekennzeichnet, dass** die Zeitkonstanten des Abklingverlaufs (208) der Spannung durch eine Padé-Laplace-Methode ermittelt werden.

7. Verfahren gemäß einem der vorhergehenden Ansprüche, **dadurch gekennzeichnet, dass** zur Ermittlung der Verletzung des Toleranzbereichs (2) der Abklingverlauf (208) der Spannung auf einen ihrer Werte normiert wird.

8. Verfahren gemäß einem der vorhergehenden Ansprüche, **dadurch gekennzeichnet, dass** die Stromstärke in Abhängigkeit von einer festgelegten Ruhespannung des Batteriemoduls (1) eingestellt wird.

9. Verfahren gemäß einem der vorhergehenden Ansprüche, **dadurch gekennzeichnet, dass** der Toleranzbereich (2) derart festgelegt wird, dass dieser Fertigungstoleranzen des Batteriemoduls (1) und/oder seiner Batteriezellen berücksichtigt.

10. Verfahren gemäß einem der vorhergehenden Ansprüche, **dadurch gekennzeichnet, dass** als Schwellenwert für den Gesundheitszustand der Batteriezellen ein Wert von 80 Prozent, bevorzugt von 70 Prozent, besonders bevorzugt von 60 Prozent festgelegt wird.

11. Verfahren gemäß einem der vorhergehenden Ansprüche, **dadurch gekennzeichnet, dass** der zeitliche Abklingverlauf (208) der Spannung mit einer zeitlichen Auflösung im Bereich von 1 Millisekunde bis 100 Millisekunden erfasst wird.

12. Verfahren nach einem der vorhergehenden Ansprüche, **dadurch gekennzeichnet, dass** die Spannung mit einer relativen Genauigkeit im Bereich von 0,1 Prozent bis 5 Prozent, insbesondere im Bereich von 0,1 Prozent bis 1 Prozent, bezüglich eines Maximalwerts der Spannung erfasst wird.

13. Verwendung (105, 106) eines Batteriemoduls (1), die davon abhängig ist, ob das Batteriemodul (1) kritisch ist, wobei das Batteriemodul (1) kritisch ist, wenn es eine oder mehrere Batteriezellen mit einem Gesundheitszustand kleiner oder gleich einem festgelegten Schwellenwert umfasst, **dadurch gekennzeichnet, dass** die Ermittlung der Kritikalität des Batteriemoduls (1) mittels eines Verfahrens gemäß einem der vorhergehenden Ansprüche durchgeführt wird.

14. Verwendung gemäß Anspruch 13, **dadurch gekennzeichnet, dass** in Abhängigkeit von der Anzahl der Batteriezellen mit einem Gesundheitszustand kleiner oder gleich dem festgelegten Schwellenwert die Verwendung eine Wiederverwendung (105), eine Wiederaufbereitung (105) oder ein Recycling (106) des Batteriemoduls (1) ist.

15. Computerprogrammprodukt, umfassend Befehle, die, wenn sie von einer Recheneinheit, insbesondere einem Computer, ausgeführt werden, diese veranlassen, ein Verfahren und/oder Schritte des Verfahrens gemäß einem der Ansprüche 1 bis 14 auszuführen.
